(19) **Europäisches Patentamt**
**European Patent Office**
**Office européen des brevets**

(11) **EP 4 064 372 A1**

(12) **EUROPEAN PATENT APPLICATION**
published in accordance with Art. 153(4) EPC

(43) Date of publication:
**28.09.2022 Bulletin 2022/39**

(21) Application number: **20888894.1**

(22) Date of filing: **04.11.2020**

(51) International Patent Classification (IPC):
*H01L 41/12* (2006.01)   *H01L 41/20* (2006.01)
*H01L 41/47* (2013.01)   *C30B 29/52* (2006.01)

(52) Cooperative Patent Classification (CPC):
**C30B 29/52; H01L 41/12; H01L 41/20; H01L 41/47**

(86) International application number:
**PCT/JP2020/041260**

(87) International publication number:
**WO 2021/100467 (27.05.2021 Gazette 2021/21)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **18.11.2019 JP 2019207723
28.08.2020 JP 2020144760**

(71) Applicant: **SUMITOMO METAL MINING CO., LTD.
Tokyo
105-8716 (JP)**

(72) Inventors:
• **OKUBO, Kazuhiko**
  **Ome-shi, Tokyo 198-8601 (JP)**
• **KAWAMURA, Shotaro**
  **Ome-shi, Tokyo 198-8601 (JP)**
• **IZUMI, Kiyoshi**
  **Ome-shi, Tokyo 198-8601 (JP)**

(74) Representative: **Müller-Boré & Partner
Patentanwälte PartG mbB
Friedenheimer Brücke 21
80639 München (DE)**

(54) **MAGNETOSTRICTIVE MEMBER AND METHOD FOR PRODUCING MAGNETOSTRICTIVE MEMBER**

(57)    A magnetostrictive member is formed of a crystal of an iron-based alloy having magnetostrictive characteristics and is a plate-like body having a long-side direction and a short-side direction. At least one of a front face and a back face of the plate-like body has a plurality of grooves extending in the long-side direction.

EP 4 064 372 A1

# Fig. 1

(A)

(B)

**Description**

Technical Field

This invention relates to a magnetostrictive member and a method for manufacturing a magnetostrictive member.

Background Art

Magnetostrictive materials are attracting attention as functional materials. For example, Fe-Ga alloys, which are iron-based alloys, are materials exhibiting the magnetostrictive effect and the reverse magnetostrictive effect, showing a large magnetostriction of about 100 to 350 ppm. For this reason, in recent years they have attracted attention as a material for vibration power generation in the energy harvesting field and are expected to be applied to wearable terminals and sensors. As a method for manufacturing a single crystal of an Fe-Ga alloy, a method for growing a single crystal by the pull-up method (the Czochralski method, hereinafter abbreviated as the "Cz method") is known (e.g., Patent Literature 1). In addition, as methods of manufacture other than the Cz method, the vertical Bridgman method (the VB method) and the vertical temperature gradient freeze method (the VGF method) are known (e.g., Patent Literature 2 and Patent Literature 3).

The Fe-Ga alloy has an easy axis of magnetization in the <100> orientation of the crystal and can exhibit large magnetic distortion in this orientation. Conventionally, magnetostrictive members of the Fe-Ga alloy have been manufactured by cutting a single crystal part oriented in the <100> orientation from an Fe-Ga polycrystal to a desired size (e.g., Non-Patent Literature 1); crystal orientation significantly affects magnetostrictive characteristics, and thus a single crystal in which the direction in which the magnetostriction of magnetostrictive members is required and the <100> orientation, in which the magnetic strain of the crystal is maximum, are matched with each other is considered to be optimum for the material of magnetostrictive members.

The single crystal of the Fe-Ga alloy exhibits positive magnetostriction when a magnetic field is applied in parallel to the <100> orientation of the single crystal (hereinafter referred to as a "parallel magnetostriction amount"). On the other hand, when a magnetic field is applied perpendicularly to the <100> orientation, negative magnetostriction is exhibited (hereinafter referred to as a "perpendicular magnetostriction amount"). As the intensity of the applied magnetic field is gradually increased, the parallel magnetostriction amount or the perpendicular magnetostriction amount is saturated. A magnetostriction constant ($3/2\lambda_{100}$) is determined by the difference between the saturated parallel magnetostriction amount and the saturated perpendicular magnetostriction amount and is determined by Expression (1) below (e.g., Patent Literature 4 and Non-Patent Literature 2).

$$\text{Expression (1)}$$
$$3/2\lambda_{100} = \varepsilon(//) - \varepsilon(\perp)$$

$3/2\lambda_{100}$: the magnetostriction constant
$\varepsilon(//)$: the parallel magnetostriction amount when saturated by applying a magnetic field in parallel to the <100> direction
$\varepsilon(\perp)$: the perpendicular magnetostriction amount when saturated by applying a magnetic field perpendicularly to the <100> direction

The magnetostrictive characteristics of the Fe-Ga alloy are considered to affect the magnetostrictive and inverse magnetostrictive effects and the characteristics of magnetostrictive vibration power generation devices and are important parameters for device design (e.g., Non-Patent Literature 4). In particular, the magnetostriction constant depends on the Ga composition of the Fe-Ga alloy single crystal, and it is known that the magnetostriction constant reaches its maximum at Ga compositions of 18 to 19 at% and 27 to 28 at% (e.g., Non-Patent Literature 2), and it is desirable to use Fe-Ga alloys with such Ga concentrations for devices. Furthermore, in recent years it has been reported that, in addition to the magnetostriction constant being large, a larger parallel magnetostriction amount tends to result in higher device characteristics such as output voltage (e.g., Non-Patent Literature 3).

A magnetostrictive vibration power generation device, for example, includes an Fe-Ga magnetostrictive member wound by a coil, a yoke, and a field permanent magnet (e.g., Patent Literature 5 and Non-Patent Literature 4). In this magnetostrictive vibration power generation device, as a mechanism, when the yoke as a movable part of the device is vibrated, the Fe-Ga magnetostrictive member fixed at the center of the yoke vibrates in tandem, the magnetic flux density of the coil wound on the Fe-Ga magnetostrictive member changes due to the reverse magnetostriction effect, and electromagnetic induction electromotive force is generated to generate power. In the magnetostrictive vibration power generation device, a force is applied in the long-side direction of the yoke to cause vibration, and thus the Fe-Ga magnetostrictive member for use in the device is desirably processed such that <100>, which is the easy axis of magnetization, is in the long-side direction.

Citation List

Patent Literature

[Patent Literature 1] Japanese Unexamined Patent Application Publication No. 2016-28831
[Patent Literature 2] Japanese Unexamined Patent Application Publication No. 2016-138028
[Patent Literature 3] Japanese Unexamined Patent Application Publication No. H04-108699
[Patent Literature 4] Japanese Translation of PCT Application Publication No. 2015-517024
[Patent Literature 5] WO2011/158473

[Non-Patent Literature]

[Non-Patent Literature 1] Etrema, State of the Art of Galfenol Processing.
[Non-Patent Literature 2] A. E. Clark et al., Appl. Phys. 93 (2003) 8621.
[Non-Patent Literature 3] Jung Jin Park, Suok-Min Na, Ganesh Raghunath, and Alison B. Flatau. AIP Advances 6, 056221 (2016).
[Non-Patent Literature 4] Toshiyuki Ueno, Journal of Japan Society for Precision Engineering Vol. 79, No. 4, (2013) 305-308.

Summary of Invention

Technical Problem

The device characteristics of magnetostrictive vibration power generation devices or the like are affected by the magnetostrictive characteristics of the magnetostrictive member, and thus the magnetostrictive member is required to have high magnetostrictive characteristics and a small variation in the magnetostrictive characteristics. Given these circumstances, it has been believed that if the crystal orientation of the single crystal of the Fe-Ga alloy is <100> and the Ga concentration is uniform, a magnetostrictive member with a uniform magnetostriction constant can be obtained. However, as described in Non-Patent Literature 3, it is disclosed that the device characteristics are affected by the parallel magnetostriction amount as well as the magnetostriction constant. Examinations by the inventor of the present invention have revealed that the magnetostrictive member manufactured as described above has a variation in the parallel magnetostriction amount (or the perpendicular magnetostriction amount) even if the magnetostriction constant is uniform and that the magnetostriction constant itself varies.
Given these circumstances, an object of the present invention is to provide a magnetostrictive member having a high magnetostriction constant and a high parallel magnetostriction amount and small variations in the magnetostriction constant and the parallel magnetostriction amount among members and a method for manufacturing a magnetostrictive member.

Solution to Problem

An aspect of the present invention provides a magnetostrictive member formed of a crystal of an iron-based alloy having magnetostrictive characteristics and being a plate-like body having a long-side direction and a short-side direction, at least one of a front face and a back face of the plate-like body having a plurality of grooves extending in the long-side direction.
The face having the grooves may have a surface roughness Ra in the long-side direction smaller than the surface roughness Ra in the short-side direction. The surface roughness Ra in the long-side direction may be 0.3 $\mu$m or more and 1.5 $\mu$m or less, and the surface roughness Ra in the short-side direction may be 0.6 $\mu$m or more and 4.5 $\mu$m or less. The magnetostrictive member may have a magnetostriction constant of 200 ppm or more and have a parallel magnetostriction amount of 200 ppm or more, the parallel magnetostriction amount being a magnetostriction amount when a magnetic field parallel to the long-side direction is applied and a magnetostriction amount in the long-side direction is saturated. The front face and the back face of the plate-like body may have the grooves. The direction of the grooves extending in the long-side direction of the magnetostrictive member may be within 30° with respect to the long-side direction. The thickness of the magnetostrictive member may be 0.3 mm or more and 2 mm or less. The crystal may be a single crystal. The iron-based alloy may be an Fe-Ga alloy. The grooves may be formed by surface grinding. The magnetostrictive member may be a plurality of magnetostrictive members manufactured from one crystal, in which the magnetostrictive members have a variation in a parallel magnetostriction amount within 10%, the parallel magnetostriction amount being a magnetostriction amount when a magnetic field parallel to the long-side direction is applied and a magnetostriction amount in the long-side direction is saturated.

An aspect of the present invention provides a method for manufacturing a magnetostrictive member including forming, on at least one of a front face and a back face of a plate-like body formed of a crystal of an iron-based alloy having magnetostrictive characteristics and having a long-side direction and a short-side direction, a plurality of grooves extending in the long-side direction.

The method for manufacturing a magnetostrictive member may include forming the grooves by surface grinding. The surface grinding may include performing using a grinding wheel of #40 or more and #500 or less. The method for manufacturing a magnetostrictive member may include forming the grooves so as to achieve a magnetostriction constant of 200 ppm or more and a parallel magnetostriction amount of 200 ppm or more, the parallel magnetostriction amount being a magnetostriction amount when a magnetic field parallel to the long-side direction is applied and a magnetostriction amount in the long-side direction is saturated. The method for manufacturing a magnetostrictive member may include manufacturing a plurality of magnetostrictive members from one crystal and, in the magnetostrictive members manufactured from the one crystal, forming the grooves so as to achieve a variation in a parallel magnetostriction amount within 10%, the parallel magnetostriction amount being a magnetostriction amount when a magnetic field parallel to the long-side direction is applied and a magnetostriction amount in the long-side direction is saturated.

Effects of Invention

The magnetostrictive member of the aspect of the present invention has the characteristics of a high magnetostriction constant and a high parallel magnetostriction amount and small variations in the magnetostriction constant and the parallel magnetostriction amount among members. The method for manufacturing a magnetostrictive member of the aspect of the present invention can easily manufacture a magnetostrictive member having a high magnetostriction constant and a high parallel magnetostriction amount and small variations in the magnetostriction constant and the parallel magnetostriction amount among members.

Brief Description of the Drawings

Figs. 1(A) and 1(B) are drawing-substitute photographs showing an example of a magnetostrictive member according to an embodiment: Fig. 1(A) is an overall image and Fig. 1(B) is a partially enlarged image of Fig. 1(A).
Fig. 2 is a flowchart of an example of a method for manufacturing a magnetostrictive member according to the embodiment.
Fig. 3 is a diagram of a first example of a single crystal, a thin plate member, and a magnetostrictive member.
Fig. 4 is a diagram of a second example of the single crystal, the thin plate member, and the magnetostrictive member.
Fig. 5 is a diagram of a third example of the single crystal, the thin plate member, and the magnetostrictive member.
Fig. 6 is a diagram of a strain gauge method used in examples.
Fig. 7 is a diagram of a magnetostrictive member of Comparative Example 1.

Description of Embodiments

The following gives a description with reference to the accompanying drawings. Part or the whole of each of the drawings is schematically described and is described on different scales as appropriate.

[Embodiment]

The following describes a magnetostrictive member and a method for manufacturing a magnetostrictive member of the present embodiment.

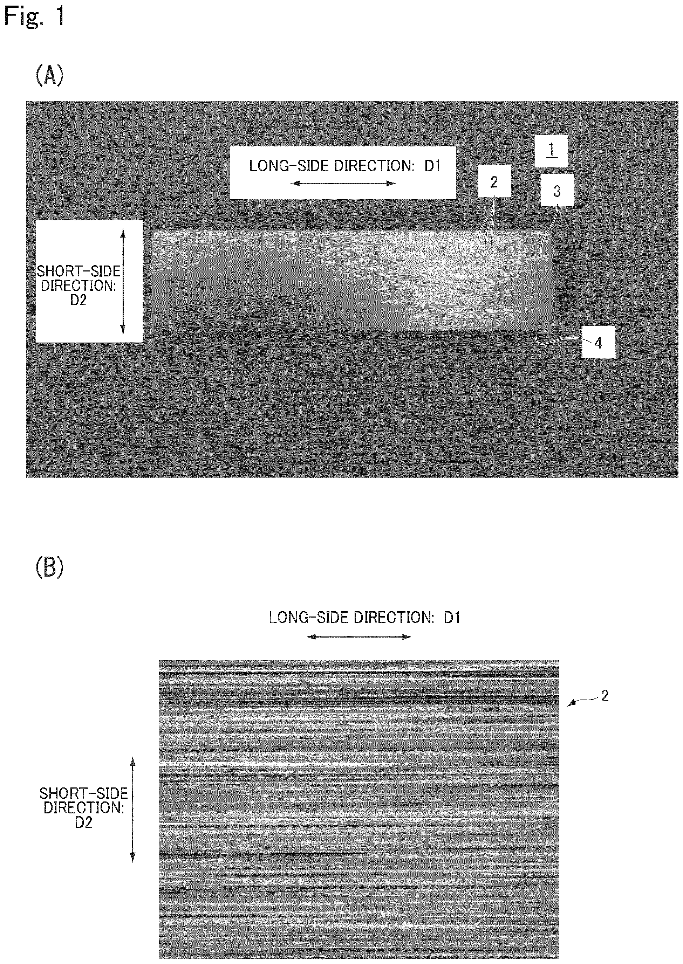

The following first describes the magnetostrictive member of the present embodiment. Figs. 1(A) and 1(B) are drawing-substitute photographs showing an example of the magnetostrictive member according to the embodiment: Fig. 1(A) is an overall image and Fig. 1(B) is a partially enlarged image of Fig. 1(A).

As illustrated in Fig. 1(A), this magnetostrictive member 1 is a plate-like body having a long-side direction D1 and a short-side direction D2. The plate-like body is a rectangular shape in a plan view. The plate-like body has a front face 3 and a back face 4. The front face 3 and the back face 4 are suitably parallel to each other but are not necessarily parallel to each other.

The magnetostrictive member 1 is formed of a crystal of an iron-based alloy. The iron-based alloy is not limited to a particular alloy so long as it has magnetostrictive characteristics. The magnetostrictive characteristics mean characteristics causing a shape change when a magnetic field is applied. The iron-based alloy is, for example, an alloy such as Fe-Ga, Fe-Ni, Fe-Al, Fe-Co, Tb-Fe, Tb-Dy-Fe, Sm-Fe, or Pd-Fe. The alloys may be alloys with a third component added. The Fe-Ga alloy, for example, may be an alloy with Ba, Cu, or the like added. Among these iron-based alloys, the Fe-Ga alloy has larger magnetostrictive characteristics and is easier to process than other alloys and thus has been applied to materials for vibration power generation in the energy harvesting field, wearable terminals, sensors, and the like. In the following description, an example of a configuration in which the magnetostrictive member 1 is formed of a single crystal of the Fe-Ga alloy will be described as an example of the magnetostrictive member 1.

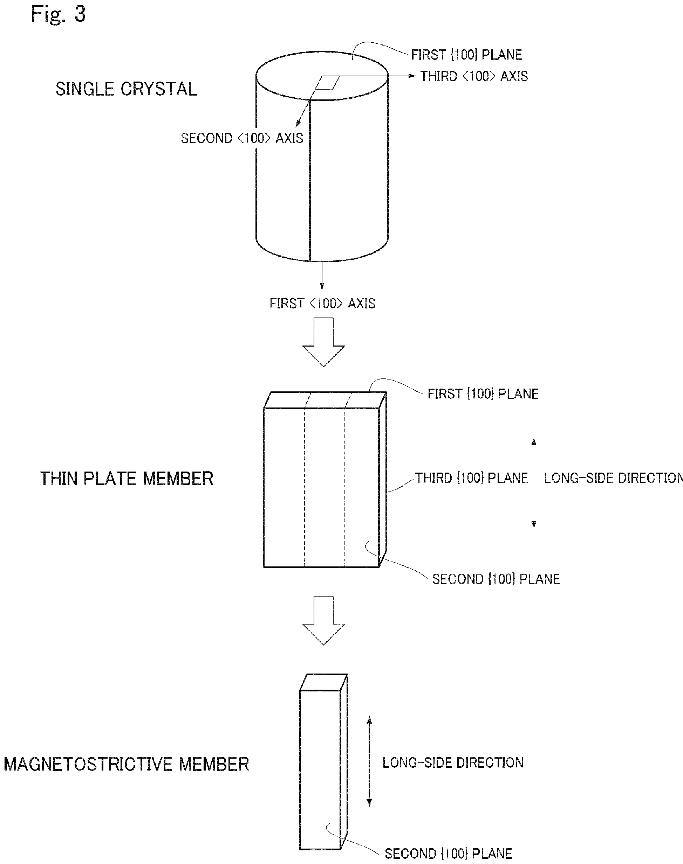

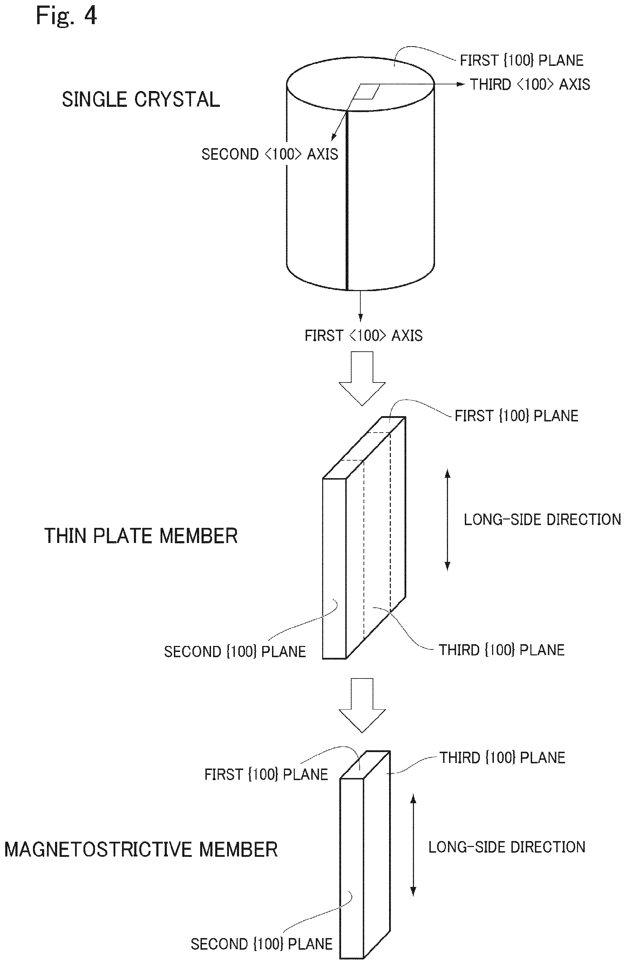

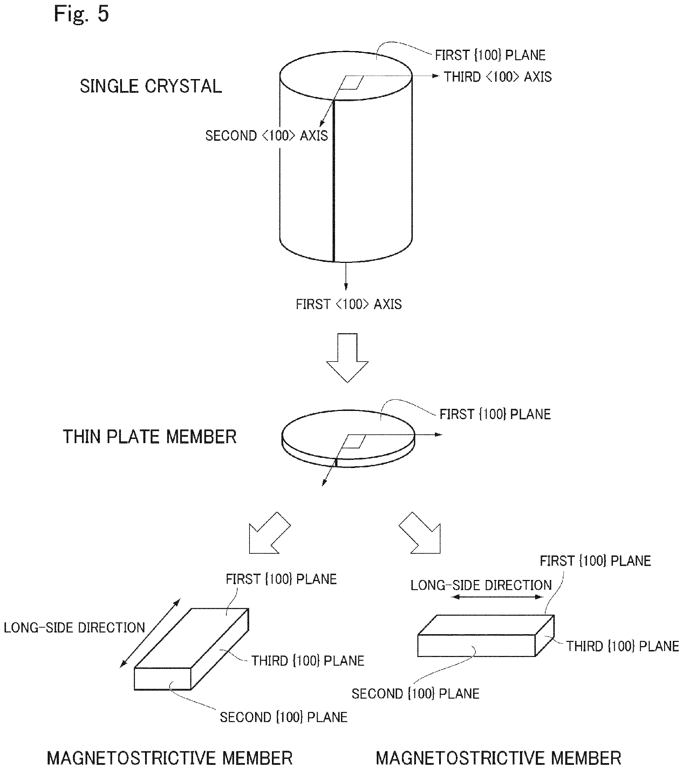

The single crystal of the Fe-Ga alloy has a bodycentered cubic lattice structure and is based on the fact that first to third <100> axes (see Fig. 3 to Fig. 5) of the directional indices in the Miller indices are equivalent and first to third {100} planes (see Fig. 3 to Fig. 5) of the plane indices in the Miller indices are equivalent (i.e., (100), (010), and (001) are equivalent). In addition, the Fe-Ga alloy has the characteristic of exhibiting large magnetic distortion in a specific orientation of the crystal. When this characteristic is used for a magnetostrictive vibration power generation device, it is desirable to match the direction in which the magnetostriction of the magnetostrictive member 1 is required in the device and the orientation (direction) in which the magnetic strain of the crystal is maximum with each other. Specifically, as described above, it is desirable to set the <100> direction, which is the easy direction of magnetization in the single crystal, to the long-side direction D1 of the magnetostrictive member 1. Setting the <100> direction, which is the easy direction of magnetization in the single crystal, to the long-side direction D1 of the magnetostrictive member 1 can be performed, for example, by calculating the crystal orientation of the single crystal by known crystal orientation analysis and cutting the single crystal on the basis of the calculated crystal orientation of the single crystal.

The crystal that can be used for the magnetostrictive member 1 of the present embodiment may be the single crystal or a polycrystal. The use of the single crystal is more advantageous than the polycrystal in order to increase the orientation integration in the <100> direction and to enhance characteristics as a magnetostrictive material. The polycrystal can be produced at low cost, although its magnetostrictive characteristics are lower than those of the single crystal, and thus the polycrystal may also be used.

The magnetostrictive member 1 is used, for example, as materials (components) for vibration power generation devices in the energy harvesting field and materials (components) for wearable terminals and sensors. For example, the magnetostrictive vibration power generation device as disclosed in Patent Literature 5 above includes a coil, an Fe-Ga alloy magnetostrictive member wound by the coil, a yoke, and a field permanent magnet. In this magnetostrictive vibration power generation device, as a mechanism, when the yoke as a movable part of the device is vibrated, the Fe-Ga magnetostrictive member fixed at the central part of the yoke vibrates in tandem, the magnetic flux density of the coil wound on the Fe-Ga magnetostrictive member changes due to the reverse magnetostriction effect, and electromagnetic induction electromotive force is generated to generate power. When used on such a mechanism, it is suitable that the shape of the magnetostrictive member 1 is like a thin plate and is set to an elongated rectangular shape in a plan view. The thickness of the magnetostrictive member 1 is not limited a particular thickness. The lower limit of the thickness is suitably 0.3 mm or more, more suitably 0.4 mm or more, and even more suitably 0.5 mm or more. The upper limit of the thickness of the magnetostrictive member 1 is suitably 2 mm or less, more suitably 1.8 mm or less, and even more suitably 1.5 mm or less. The thickness of the magnetostrictive member 1 is suitably 0.3 mm or more and 2 mm or less, more suitably 0.4 mm or more and 1.8 mm or less, and even more suitably 0.5 mm or more and 1.5 mm or less. The mechanism of power generation by the magnetostrictive member 1 is, as described above, a mechanism to generate power by the reverse magnetostriction effect by applying stress to the magnetostrictive member (vibration). When the thickness of the magnetostrictive member 1 is less than 0.3 mm, it is easily damaged during vibration. When the thickness of the magnetostrictive member 1 exceeds 2 mm, on the other hand, the stress due to vibration is required to be increased, resulting in lower efficiency. The shape and the size of the magnetostrictive member 1 are set as appropriate in accordance with the size of an objective device. For example, the size of the magnetostrictive member 1 includes a length (dimension) L1 in the long-side direction D1 of 16 mm, a width (dimension) L2 in the short-side direction D2 of 4 mm, and a thickness of 1 mm.

The shape and the dimensions of the magnetostrictive member 1 are not limited to particular ones. For example, the magnetostrictive member 1 need not be a rectangular shape in a plan view. For example, the shape of the magnetostrictive member 1 may be elliptic, track-shaped, or irregular in a plan view. When the shape of the magnetostrictive member 1 is other than the rectangular shape in a plan view, the long-side direction D1 is a long-diameter direction, a long-axis direction, or the like, whereas the short-side direction D2 is a direction orthogonal to the long-side direction D1.

As described above, the inventors of the present invention produced a plurality of plate-like magnetostrictive members formed of the single crystal of the Fe-Ga alloy, with the {100} plane as the principal plane, and with a rectangular shape in a plan view with the <100> direction, which is the easy direction of magnetization, as the long-side direction of the magnetostrictive member. Checking the magnetostrictive characteristics of the magnetostrictive members produced by being cut out of the single crystal of the Fe-Ga alloy with a uniform Ga concentration revealed that the produced magnetostrictive members had a large variation in the parallel magnetostriction amount, although they had a high-level magnetostriction constant. It was also found out that in these magnetostrictive members, the magnetostriction constant itself might vary and that the magnetostriction constant varied depending on the position at which the magnetostrictive member was cut out of the single crystal. After further examinations, it was also found out that the magnetostriction constant and the parallel magnetostriction amount were related to a grinding direction of the magnetostrictive member. The present invention has been made on the basis of the above findings.

A magnetostrictive member is manufactured, for example, by cutting a grown crystal of an iron-based alloy in a certain direction to produce a thin plate-like member and then cutting the produced thin plate-like member into a predetermined size. Conventional magnetostrictive members have been subjected to polishing or the like on the front and back faces of the magnetostrictive members to finish the front and back faces to be smooth.

As illustrated in Figs. 1(A) and 1(B), at least one of the front face 3 and the back face 4 (may be collectively referred to as "front and back faces") of the magnetostrictive member 1 of the present embodiment has a plurality of grooves 2 extending in the long-side direction D1. The following gives a detailed description.

As described above, checking the magnetostrictive characteristics of the magnetostrictive members cut out of the Fe-Ga single crystal with a uniform Ga concentration reveals that they have a variation in the parallel magnetostriction amount, although they have a high-level magnetostriction constant. The present embodiment, even in such a magnetostrictive member with a variation in the parallel magnetostriction amount, can modify both the magnetostriction constant and the parallel magnetostriction amount so as to be a high level and have small variations among members (also referred to as "modification of the magnetostriction constant and the parallel magnetostriction amount") and can modify the parallel magnetostriction amount in particular by forming the grooves 2 extending in the long-side direction D1 on at least one of the front and back faces of the magnetostrictive member. This phenomenon of modification is presumed to be caused by the formation of the grooves 2, thereby applying stress such as residual strain within the crystal, rearranging magnetic moments uniformly, and making the magnetostrictive characteristics uniform.

The following describes the modification of the magnetostriction constant and the parallel magnetostriction amount. In the present embodiment, as shown in the examples described below, in samples of the magnetostrictive member with a low parallel magnetostriction amount before forming the grooves 2, the grooves 2 with different directions of extension were formed on both the front and back faces of the magnetostrictive member, and changes in the magnetostriction constant and the parallel magnetostriction amount due to the formation of the grooves 2 were examined. In the present embodiment, the magnetostriction constant and the parallel magnetostriction amount were measured when the grooves 2 extending in the same direction as the long-side direction D1 were formed in the magnetostrictive member (Examples 3, 13, 16, 17, 19, etc.) and when the grooves 2 extending in the same direction as the short-side direction D2 were formed (Comparative Examples 2, 3, etc.). Table 1 lists the results.

In the samples of the magnetostrictive member with a low parallel magnetostriction amount before forming the grooves 2, when the grooves 2 extending in the same direction as the long-side direction D1 are formed in the magnetostrictive member (e.g., Examples 3, 13, 16, 17, 19, etc.), by forming the grooves 2, the magnetostriction constant and the parallel magnetostriction amount change from a low level to a high level and are stabilized at the high level. In particular, the parallel magnetostriction amount markedly increases by forming the grooves 2. The values of the magnetostriction constant and the parallel magnetostriction amount had small variations among members (among samples).

In contrast, in the samples of the magnetostrictive member with a low parallel magnetostriction amount before forming the grooves 2, when the grooves 2 extending in the same direction as the short-side direction D2 are formed in the magnetostrictive member (Comparative Examples 2 and 3), the parallel magnetostriction amount is stabilized at a low level as before forming the grooves 2. The value of the parallel magnetostriction amount had a small variation among members (among samples).

Furthermore, in the present embodiment, in samples of the magnetostrictive member with a high parallel magnetostriction amount before forming the grooves 2 as well, the grooves 2 with different directions of extension were formed on both the front and back faces of the magnetostrictive member, and changes in the magnetostriction constant and the parallel magnetostriction amount due to the formation of the grooves 2 were examined. In the present embodiment, the magnetostriction constant and the parallel magnetostriction amount were measured when the grooves 2 extending in the same direction as the long-side direction D1 were formed in the magnetostrictive member (Examples 2, 5, 6 to 11, etc.) and when the grooves 2 extending in the same direction as the short-side direction D2 were formed (Comparative Examples 1 and 4).

In the samples of the magnetostrictive member with a high parallel magnetostriction amount before forming the grooves 2, when the grooves 2 extending in the same direction as the long-side direction D1 are formed in the magnetostrictive member (Examples 2, 5, 6 to 11, etc.), the magnetostriction constant and the parallel magnetostriction amount are stabilized at a high level as before forming the grooves 2. The values of the magnetostriction constant and the parallel magnetostriction amount had small variations among members (among samples).

In contrast, in the samples of the magnetostrictive member with a high parallel magnetostriction amount before forming the grooves 2, when the grooves 2 extending in the same direction as the short-side direction D2 are formed in the magnetostrictive member (Comparative Examples 1 and 4), the high level before forming the grooves 2 changes to a low level, and the low level is stabilized. The value of the parallel magnetostriction amount had a small variation among members (among samples).

From the above results, it is found that the magnetostriction constant and the parallel magnetostriction amount are affected by the surface condition of the magnetostrictive member. It is found that by forming the grooves 2 extending in the long-side direction D1 on at least one of the front face 3 and the back face 4 of the magnetostrictive member, both the magnetostriction constant and the parallel magnetostriction amount can be modified (corrected) so as to be a high level and have small variations among members.

In the present embodiment, in Examples 34 to 37 and Comparative Examples 7 to 9, the magnetostriction constant and the parallel magnetostriction amount were measured when the grooves 2 extending in the directions of 0° to 60° with respect to the long-side direction D1 were formed. Table 6 lists the results. In the samples of the magnetostrictive member with a low parallel magnetostriction amount before forming the grooves 2, when the grooves 2 extending in the direction of 0° to 60° with respect to the long-side direction D1 are formed, the parallel magnetostriction amount increases along with the formation of the grooves 2 and tends to be a value the same level as that in the case in which the grooves 2 extending in the same direction as the long-side direction D1 are formed as the angle between the direction of extension of the grooves 2 and the long-side direction D1 is closer to 0° and to be close to the value in the case in which the grooves 2 extending in the same direction as the short-side direction D2 are formed as the angle becomes larger. The value of the parallel magnetostriction amount was an approximately midway value between the value at 0° and the value at 60° near 45° with respect to the long-side direction D1. This angle (the angle between the direction of extension of the grooves 2 and the long-side direction D1) is suitably less than 40°, more suitably 35° or less, and more suitably within 30°. When the angle is in the above suitable range, the effect of the modification of the magnetostriction constant and the parallel magnetostriction amount is expressed more surely. When the angle is within 30°, the parallel magnetostriction amount can be controlled at a high level of 200 ppm or more surely.

It is found from the above results that by forming the grooves 2 extending in the long-side direction D1 on at least one of the front face 3 and the back face 4 of the magnetostrictive member, variations in the magnetostriction constant and the parallel magnetostriction amount derived from differences in relative positions within the single crystal and the like are suppressed, the magnetostriction constant and the parallel magnetostriction amount are stabilized at a high level, and this tendency is conspicuous for the parallel magnetostriction amount. It is found from the above results that the parallel magnetostriction amount is determined in accordance with the angle between the long-side direction D1 and the direction of extension of the grooves 2, and the parallel magnetostriction amount is higher when the long-side direction D1 and the direction of extension of the grooves 2 are parallel to each other, in which case it is presumed to be maximum. As described above, the grooves 2 extending in the long-side direction D1 included in the magnetostrictive member 1 of the present embodiment can modify both the magnetostriction constant and the parallel magnetostriction amount (at least the parallel magnetostriction amount). The grooves 2 extending in the long-side direction D1 included in the magnetostrictive member 1 of the present embodiment enables modification to markedly increase the parallel magnetostriction amount (e.g., 200 ppm or more, suitably 250 ppm or more) in a magnetostrictive member with a low parallel magnetostriction amount (e.g., 50 ppm or less) when finished to be smooth by polishing manufactured under the conditions shown in Example 2.

The parallel magnetostriction amount is a magnetostriction amount when a magnetic field parallel to the long-side direction D1 of the magnetostrictive member 1 is applied and a magnetostriction amount in the long-side direction D1 is saturated. The perpendicular magnetostriction amount is a magnetostriction amount when a magnetic field parallel to the short-side direction D2 of the magnetostrictive member 1 is applied and a magnetostriction amount in the short-side direction D2 is saturated. The magnetostriction constant, the parallel magnetostriction amount, and the perpendicular magnetostriction amount in the magnetostrictive member 1 of the present embodiment are values determined as described in the examples to be explained later, the magnetostriction amounts are values determined by correcting an actual strain detection value by a gauge factor in accordance with Expression (3), in which the magnetostriction amount when a magnetic field direction is parallel to the long-side direction of a strain gauge is defined as the parallel magnetostriction amount, whereas the magnetostriction amount when the magnetic field direction is perpendicular to the long-side direction of the strain gauge is defined as the perpendicular magnetostriction amount, and the magnetostriction constant is a value determined by the difference between the parallel magnetostriction amount and the perpendicular magnetostriction amount in accordance with Expression (1). The angle between the direction of extension of the grooves 2 and the long-side direction D1 is a value obtained by averaging values of a plurality of different grooves.

The following describes the grooves 2. The grooves 2 are formed on at least one of the front face 3 and the back face 4. In the example illustrated in Figs. 1(A) and 1(B), the grooves 2 are formed on both the front face 3 and the back face 4. When the grooves 2 are formed on one of the front face 3 and the back face 4, there is a tendency that the effect of the modification of the magnetostriction constant and the parallel magnetostriction amount is less effective and variations in the magnetostrictive characteristics are larger than those of the case in which the grooves 2 are formed on both the front face 3 and the back face 4, and thus the grooves 2 are suitably formed on both the front face 3 and the back face 4.

The grooves 2 are formed so as to extend in the long-side direction D1. Each of the grooves 2 is linear (striated). Each of the grooves 2 is suitably straight from the viewpoint of efficiently expressing the effect of the modification of the magnetostriction constant and the parallel magnetostriction amount. Each of the grooves 2 may be curved. The length of each of the grooves 2 in the long-side direction D1 is not limited to a particular length. The grooves 2 are suitably formed uniformly within the plane at predetermined intervals in the short-side direction D2 and are suitably formed throughout the entire plane from the viewpoint of efficiently expressing the effect of the modification of the magnetostriction constant and the parallel magnetostriction amount. In this embodiment, the magnetostrictive member 1 may include grooves extending in directions other than the long-side direction to the extent that the effect of the invention is not impaired, and such a magnetostrictive member is not excluded, but ideally there are suitably no grooves extending in directions other than the long-side direction.

In the present embodiment, the grooves 2 extending in the long-side direction D1 includes the grooves 2 extending in a direction parallel to the long-side direction D1 and the grooves 2 extending in a direction intersecting the long-side direction D1 at an angle of less than 40°. As described above, if the direction of extension of the grooves 2 deviates from the direction parallel to the long-side direction D1, the parallel magnetostriction amount becomes low, and thus the direction of extension of the grooves 2 is suitably the direction parallel to the long-side direction D1.

The grooves 2 illustrated in Fig. 1(B) can be formed, for example, by performing surface grinding on at least one of the front face 3 and the back face 4 of a thin plate member obtained by cutting a single crystal. In this case, the grooves 2 are grinding marks (grinding striations) formed on the processed face on which the surface grinding has been performed. The grinding marks are marks formed by a grinding wheel during the surface grinding. These grinding marks are marks formed in a striated manner (a linear manner) along a grinding direction (a moving direction of the grinding wheel or a moving direction of a processing table) by the surface grinding. The direction of the grinding marks (the direction of extension of the grooves 2) can be controlled by controlling the grinding direction. The grinding marks can be controlled by the grain size (grit) of the grinding wheel. The condition of the grooves 2 formed by the surface grinding can be checked with a microscope or the like. The method for forming the grooves 2 is not limited to the surface grinding as will be described later. The grooves 2 may include grooves extending in different directions and include grooves of shapes with different lengths or depths.

As to a surface roughness Ra of the face formed with the grooves 2, the surface roughness Ra in the long-side direction D1 is usually smaller than the surface roughness Ra in the short-side direction D2. The grooves 2 are formed in a linear manner (a striated manner) so as to extend in the long-side direction D1. Thus, the short-side direction D2 of the magnetostrictive member 1 has an uneven shape, and thus the surface roughness Ra is larger than that in the long-side direction D1. The long-side direction D1 of the magnetostrictive member 1 follows the linear (striated) grooves 2 extending in the long-side direction D1, and thus the surface roughness Ra is smaller than that in the short-side direction D2. In this embodiment, the surface roughness Ra is a value obtained by averaging values measured on a plurality of different parts in one magnetostrictive member 1.

On the face formed with the grooves 2, the surface roughness Ra in the long-side direction D1 is smaller than the surface roughness Ra in the short-side direction D2. On the face formed with the grooves 2, the surface roughness Ra in the long-side direction D1 has a lower limit of suitably 0.3 $\mu$m or more, has an upper limit of suitably 1.5 $\mu$m or less, and is more suitably 0.3 $\mu$m or more and 1.5 $\mu$m or less. On the face formed with the grooves 2, the surface roughness Ra in the short-side direction D2 has a lower limit of suitably 0.6 $\mu$m or more and more suitably 0.7 $\mu$m or more, has an upper limit of suitably 4.5 $\mu$m or less, and has a range of suitably 0.6 $\mu$m or more and 4.5 $\mu$m or less and more suitably 0.7 $\mu$m or more and 4.5 $\mu$m or less. When the surface roughness Ra in the long-side direction D1 or the short-side direction D2 on the face formed with the grooves 2 is in the above range, the effect of the modification of the magnetostriction constant and the parallel magnetostriction amount can be efficiently expressed.

The following describes the characteristics of the magnetostrictive member 1 of the present embodiment. The magnetostrictive member 1 of the present embodiment can have a magnetostriction constant of 200 ppm or more and suitably 250 ppm or more by the above configuration. The magnetostrictive member 1 can have a parallel magnetostriction amount of 200 ppm or more and suitably 250 ppm or more by the above configuration. When the magnetostriction constant and the parallel magnetostriction amount of the magnetostrictive member 1 are in the above ranges, the magnetostrictive member 1 is suitably formed of the single crystal of the Fe-Ga alloy.

In the magnetostrictive member 1 of the present embodiment, both the magnetostriction constant and the parallel magnetostriction amount are modified (corrected) so as to be a high level and have small variations among members by forming the grooves 2 extending in the long-side direction D1 on at least one of the front face 3 and the back face 4 of the magnetostrictive member. Thus, the magnetostrictive member 1 of the present embodiment, in the case of a plurality of the magnetostrictive members 1 manufactured from one crystal, can make a variation in the magnetostriction constant within 15% and a variation in the parallel magnetostriction amount within 10% in the magnetostrictive members 1. The magnetostrictive member 1 of the present embodiment, in the case of the magnetostrictive members 1 manufactured from one crystal, can make the variation coefficient of the magnetostriction constant in the magnetostrictive members 1 suitably 0.1 or less and more suitably 0.06 or less and make the variation coefficient of the parallel magnetostriction amount suitably 0.1 or less and more suitably 0.05 or less. In the present embodiment, the variation in the magnetostriction constant and the parallel magnetostriction amount in the magnetostrictive members 1 is a value calculated by Expression (2) below.

```
Expression (2)
Variation (%) = |Difference between average and largest
outlier|/Average
```

The grown one crystal is an effective crystal used as the magnetostrictive member (part actually used as a component) out of the grown crystal. For example, it is a range with a solidification rate of 10% to 85% for a crystal grown by the BV method and a range with a uniform diameter (part excluding a grown shoulder part and the like) for a crystal grown by the CZ method.

As described above, the magnetostrictive member 1 of the present embodiment is formed of a crystal of an iron-based alloy having magnetostrictive characteristics and is a plate-like body having a long-side direction and a short-side direction, in which at least one of a front face and a back face of the plate-like body has a plurality of grooves extending in the long-side direction. In the magnetostrictive member 1 of the present embodiment, any configuration other than the above is optional. The magnetostrictive member 1 of the present embodiment has the characteristics of a high magnetostriction constant and a high parallel magnetostriction amount and small variations in the magnetostriction constant and the parallel magnetostriction amount among members. In the magnetostrictive member 1 of the present embodiment, the modification of the magnetostriction constant and the parallel magnetostriction amount is performed, and variations in the magnetostriction constant and the parallel magnetostriction amount in conventional magnetostrictive members manufactured from the same single crystal are corrected, and thus it can be produced stably with high yield. The magnetostrictive member 1 of the present embodiment has a high magnetostriction constant and a high parallel magnetostriction amount and can thus be suitably used as an end product of a member (material) exhibiting excellent magnetostriction and reverse magnetostriction effects.

The following describes a method for manufacturing a magnetostrictive member of the present embodiment. The method for manufacturing a magnetostrictive member of the present embodiment is a method for manufacturing the magnetostrictive member 1 of the present embodiment described above. The method for manufacturing a magnetostrictive member of the present embodiment includes forming, on at least one of the front face 3 and the back face 4 of the plate-like body formed of the crystal of the iron-based alloy having magnetostrictive characteristics and having the long-side direction D1 and the short-side direction D2, the grooves 2 extending in the long-side direction D1. In the following description, a method for manufacturing the magnetostrictive member 1 from a single crystal ingot of the Fe-Ga alloy will be described as an example; the method for manufacturing a magnetostrictive member of the present embodiment is not limited to the following description. It is assumed that any description in the present specification that is applicable to the method for manufacturing the magnetostrictive member of the present embodiment is also applicable to the method for manufacturing a magnetostrictive member of the present embodiment.

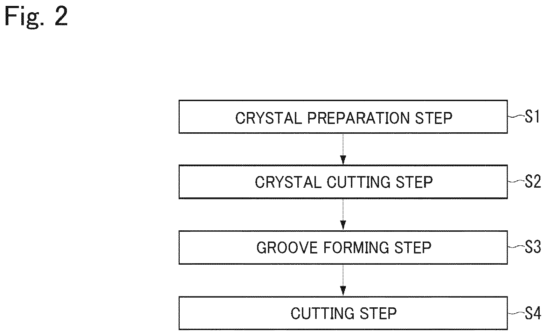

Fig. 2 is a flowchart of an example of the method for manufacturing a magnetostrictive member of the embodiment. Fig. 3 to Fig. 5 are diagrams of first to third examples of a single crystal, a thin plate member, and a magnetostrictive member. This method for manufacturing a magnetostrictive member of the present embodiment includes a crystal preparation step (Step S1), a crystal cutting step (Step S2), a groove forming step (Step S3), and a cutting step (Step S4).

In the method for manufacturing a magnetostrictive member of the present embodiment, first, in the crystal preparation step (Step S1), a crystal of an iron-based alloy having magnetostrictive characteristics is prepared. The crystal to be prepared may be a single crystal or a polycrystal. The crystal to be prepared may be a grown one or commercially available one. For example, in the crystal preparation step, a single crystal of an Fe-Ga alloy is prepared. The method for growing the single crystal of the Fe-Ga alloy is not limited to a particular method. The method for growing the single crystal of the Fe-Ga alloy may be, for example, the pull-up method or the unidirectional solidification method. For example, the Cz method can be used for the pull-up method, and the VB method, the VGF method, the micro pull-down method, and the like can be used for the unidirectional solidification method.

For the single crystal of the Fe-Ga alloy, the magnetostriction constant is maximized by setting a gallium content to 18.5 at% or 27.5 at%. For this reason, the single crystal of the Fe-Ga is grown so as to have a gallium content of suitably 16.0 to 20.0 at% or 25.0 to 29.0 at% and more suitably 17.0 to 19 at% or 26.0 to 28.0 at%. The shape of the grown single crystal is not limited to a particular shape and may be cylindrical or quadrangular prismatic, for example. The grown single crystal may be made into a cylindrical single crystal by cutting a seed crystal, a diameter-increased part, a shoulder part (the part increasing the diameter from the seed crystal to a predetermined single crystal), or the like with a cutting apparatus, if necessary. The size of the single crystal to be grown is not limited to a particular size so long as it is large enough to ensure the magnetostrictive member in a predetermined direction. When growing the Fe-Ga single crystal, it is grown using a seed crystal processed with the upper face or the lower face of the seed crystal to be the {100} plane so that a growing axis direction is <100>. In the Fe-Ga alloy single crystal to be grown, the crystal is grown in a direction perpendicular to the upper face or the lower face of the seed crystal, and the orientation of the seed crystal is inherited.

Following the crystal preparation process (Step S1), the crystal cutting step (Step S2) is performed. The crystal cutting step is a step cutting the crystal to produce a thin plate member. The thin plate member is a member to be a material of the magnetostrictive member 1 of the present embodiment. The crystal cutting step is a step, for example, cutting the single crystal of the Fe-Ga alloy having magnetostrictive characteristics using a cutting apparatus to produce the thin plate member with the {100} plane as its principal plane. As the cutting apparatus, a cutting apparatus such as a wire electric discharge machine, an inner peripheral blade cutting apparatus, or a wire saw can be used. Among these, the use of a multi-wire saw is particularly suitable because it can cut a plurality of thin plate members at the same time. The cutting direction of the single crystal in the case of the Fe-Ga single crystal is <100>, and cutting is performed such that a cut plane, that is, the principal plane of the thin plate member is the {100} plane. The cutting direction of the single crystal is not limited to a particular direction. The cutting direction of the single crystal may be a perpendicular direction or a parallel direction with respect to the growing direction of the single crystal (the direction in which the crystal is grown) as illustrated in Fig. 3 to Fig. 5, for example.

Following the crystal cutting step (Step S2), the groove forming step (Step S3) is performed. The groove forming step forms the grooves 2 on at least one of the front face 3 and the back face 4 of the obtained thin plate member. In the groove forming step, the grooves 2 are formed in the thin plate member such that when the thin plate member is finally cut and made into the magnetostrictive member 1, the grooves 2 extending in the long-side direction D1 of the magnetostrictive member 1 are formed. As described above, the grooves 2 can be formed by performing the surface grinding on at least one of the front and back faces of the thin plate member obtained by the crystal cutting step. The following describes an example in which the groove forming step is performed by the surface grinding on the thin plate member. When the grooves 2 are formed by the surface grinding, the effect of the modification of the magnetostriction constant and the parallel magnetostriction amount can be efficiently expressed.

The surface grinding is performed using a surface grinder. From the viewpoint of efficiently expressing the effect of the modification of the magnetostriction constant and the parallel magnetostriction amount, the surface grinding is suitably performed such that the direction of the grinding marks formed on the thin plate member is a direction parallel to the long-side direction D1 of the magnetostrictive member 1. For this reason, the grinding marks are suitably straight. To make the grinding marks straight, the surface grinder is suitably of a type in which the moving direction of a grinding wheel or a processing table is straight, and the surface grinder of a type including a flat grinding wheel and in which the processing table reciprocates is suitably used. The surface grinder including a cup grinding wheel and in which the processing table rotates can also be used; when using such a surface grinder, the grinding marks are curved, and thus it is suitable to set the curvature of the grinding marks to be small (less curved).

The grinding marks are required to be formed on the surface of the magnetostrictive member 1. For this reason, when processing is performed by thickness adjustment or the like of the thin plate member, the surface grinding may be performed after predetermined processing is performed with a processing machine other than the surface grinder such as a double-sided lapping apparatus or the surface grinder including a cup grinding wheel or the like. The surface of the thin plate member (the magnetostrictive member) may be finished to be a mirror surface by performing polishing as in a conventional manner, followed by the surface grinding. From the viewpoint of efficiently expressing the effect of the modification of the magnetostriction constant and the parallel magnetostriction amount, the surface grinding is suitably performed on both the front and back faces of the thin plate member.

The grinding wheel used for the surface grinding has a lower limit of the roughness (grit) of the grinding wheel of suitably #40 or more and more suitably #100 or more, has an upper limit of suitably #500 or less and more suitably #400 or less, and has a range of suitably #40 or more and #500 or less, more suitably #40 or more and #400 or less, and more suitably #100 or more and #400 or less, for example. When the roughness (grit) of the grinding wheel is in the above range, the effect of the modification of the magnetostriction constant and the parallel magnetostriction amount can be more surely demonstrated. Note that if a grinding wheel smaller than #40 is used, the size of the grinding marks is not necessarily stabilized. If a grinding wheel exceeding #500 is used, the surface of the magnetostrictive member may become smooth and the effect of the modification of the magnetostriction constant and the parallel magnetostriction amount may not be efficiently expressed.

In the groove forming step, as described above, the grooves 2 are suitably formed in the magnetostrictive member 1 such that the surface roughness Ra of the face formed with the grooves 2 in the long-side direction D1 is in the suitable range described above. For example, the grooves 2 are suitably formed so as to have a lower limit of suitably 0.3 $\mu$m or more, an upper limit of suitably 1.5 $\mu$m or less, and a range of 0.3 $\mu$m or more and 1.5 $\mu$m or less. The grooves 2 are suitably formed in the magnetostrictive member 1 such that the surface roughness Ra of the face formed with the grooves 2 in the short-side direction D2 has a lower limit of suitably 0.6 $\mu$m or more and more suitably 0.7 $\mu$m or more, a lower limit of suitably 4.5 $\mu$m or less, and a range of suitably 0.6 $\mu$m or more and 4.5 $\mu$m or less. The grooves 2 are suitably formed in the magnetostrictive member 1 such that the magnetostriction constant and the parallel magnetostriction amount are in the ranges described above. For example, the grooves 2 are suitably formed in the magnetostrictive member 1 such that the magnetostriction constant is 200 ppm or more and the parallel magnetostriction amount is 200 ppm or more. The grooves 2 giving the surface roughness Ra, the magnetostriction constant, and the parallel magnetostriction amount in the suitable ranges can be formed by the surface grinding described above. The groove forming step may be performed by a method other than the surface grinding if it can form the grooves 2 on at least one of the front face 3 and the back face 4 of the obtained thin plate member. For example, the thin plate member may be produced with a fixed abrasive grain type wire saw. That is to say, the grooves 2 may be grooves formed when the crystal is sliced with the fixed abrasive grain type wire saw to produce the thin plate member. Cutting with the wire saw includes the free abrasive grain type performing cutting by pressing a workpiece against a plurality of ultrathin wire rows parallel to each other at a fixed pitch and supplying a processing fluid (also called slurry) containing abrasive grains to between the workpiece and the wire while feeding the wire in the wire direction and the fixed abrasive grain type cutting a workpiece while feeding a wire with abrasive grains such as diamond secured with electrodeposition or adhesive in the wire direction. Although the cut plane by the free abrasive grain type becomes pear-skin without directionality, and the present effect cannot be obtained, when cutting is performed with a wire saw of the fixed abrasive grain type, grinding marks are generated in the wire feeding direction, and the grooves 2 similar to those by the surface grinding can be formed. When performing cutting with the wire saw of the fixed abrasive grain type, the crystal cutting step (Step S2) and the groove forming step (step S3) can be shared, and thus the thin plate member can be efficiently produced. The grooves 2 may be formed by applying a certain amount of pressure with sandpaper or the like.

Following the groove forming step (Step S3), the cutting step (Step S4) is performed. The cutting step is a step cutting the thin plate member formed with the grooves 2 by the groove forming step to obtain the magnetostrictive member 1 of the present embodiment.

In the cutting step, when the thin plate member formed with the grooves 2 is cut to be made into the magnetostrictive member 1, the thin plate member is cut so as to form the grooves 2 extending in the long-side direction D1 of the magnetostrictive member 1. In the cutting step, the thin plate member is cut into a predetermined size. In the cutting step, the thin plate member is cut as the magnetostrictive member 1 such that the magnetostrictive member 1 becomes a rectangular plate-like body in a plan view. In the cutting step, the thin plate member is cut using a cutting apparatus. The cutting apparatus used in the cutting step is not limited to a particular cutting apparatus; for example, an outer peripheral blade cutting apparatus, a wire electric discharge machine, a wire saw, or the like can be used. The direction in which the magnetostrictive member is extracted from the thin plate member, which is not limited to a particular direction, may be set to a direction allowing efficient acquisition depending on the size of the magnetostrictive member or the like, for example.

As described above, the method for manufacturing a magnetostrictive member of the present embodiment includes forming, on at least one of the front face 3 and the back face 4 of the plate-like body formed of the crystal of the iron-based alloy having magnetostrictive characteristics and having the long-side direction D1 and the short-side direction D2, the grooves 2 extending in the long-side direction D1. In the method for manufacturing a magnetostrictive member of the present embodiment, any configuration other than the above is optional. The method for manufacturing a magnetostrictive member of the present embodiment can manufacture a magnetostrictive member having the characteristics of a high magnetostriction constant and a high parallel magnetostriction amount and small variations in the magnetostriction constant and the parallel magnetostriction amount among members. The method for manufacturing a magnetostrictive member of the present embodiment only requires the formation of the grooves 2 in a material having magnetostrictive characteristics and can thus be easily implemented.

Conventionally, in magnetostrictive members extracted from the same single crystal, there have been variations in the parallel magnetostriction amount depending on the extraction position of the magnetostrictive members from the single crystal, and the magnetostrictive members with a high-level parallel magnetostriction amount have been selected; the method for manufacturing a magnetostrictive member of the present embodiment performs the modification of the magnetostriction constant and the parallel magnetostriction amount and corrects variations in the magnetostriction constant and the parallel magnetostriction amount in the conventional magnetostrictive members manufactured from the same single crystal and can thus produce a magnetostrictive member having the characteristics of a high magnetostriction constant and a high parallel magnetostriction amount and small variations in the magnetostriction constant and the parallel magnetostriction amount among members stably with high yield.

Examples

The following specifically describes the present invention in detail with reference to examples; the present invention is not limited by these examples at all.

[Example 1]

With raw materials adjusted with a stoichiometric ratio of iron to gallium of 81:19, a cylindrical single crystal of an Fe-Ga alloy grown by the vertical Bridgman (VB) method was prepared. The growth axis direction of the single crystal was <100>. In the {100} plane of the upper face or the lower face of the single crystal perpendicular to the crystal growth axis direction, the orientation was confirmed by X-ray diffraction. In this process, upper face and lower face samples of the crystal were measured with a Shimadzu sequential plasma emission spectrometer (ICPS-8100), and the concentration of the single crystal had a gallium content of 17.5 to 19.0 at%.

A magnetostrictive member was manufactured from the grown single crystal as follows. First, using a free abrasive grain type wire saw apparatus, the single crystal was cut in a direction parallel to the single crystal growth direction (parallel to the <100> orientation) to produce a thin plate member with a cut plane, that is, a principal plane of {100}. Then, the obtained thin plate member was subjected to surface grinding with a surface grinder using a flat grinding wheel of #200 to adjust the thickness of the thin plate member and to form a plurality of grooves (grinding marks) on the front and back faces. Then, a cutting position was set such that the long-side direction of the magnetostrictive member was in the same direction as a grinding direction during the surface grinding, that is, a grinding mark direction, and the magnetostrictive member with a size including a dimension in the long-side direction of 16 mm × a dimension in the short-side direction of 4 mm × a thickness of 1 mm was cut out with an outer peripheral blade cutting apparatus.

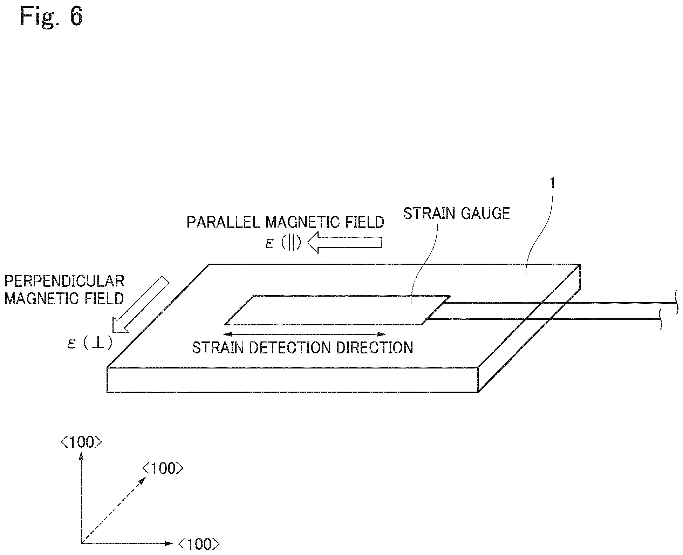

Next, magnetostrictive characteristics were measured for the cut-out magnetostrictive member. Measurement of the magnetostrictive characteristics was performed by the strain gauge method. As illustrated in Fig. 6, a strain gauge (manufactured by Kyowa Electronic Instruments Co., Ltd.) was bonded to the {100} plane, which is the principal plane of the manufactured magnetostrictive member, using adhesive. The long-side direction of the strain gauge is a magnetostriction detection direction, and thus the strain gauge was bonded such that its long-side direction was parallel to the long-side direction of the magnetostrictive member and the <100> orientation.

A magnetostriction measuring instrument (manufactured by Kyowa Electronic Instruments Co., Ltd.) included a neodymium-based permanent magnet, a bridge box, a compact recording system, a strain unit, and dynamic data acquisition software.

The magnetostriction amount was determined by correcting an actual strain detection value by a gauge factor.

The gauge factor was determined by Expression (3) below.

$$\text{Expression (3)}$$
$$\varepsilon = 2.00/Ks \times \varepsilon i$$

($\varepsilon$: the gauge factor, $\varepsilon i$: a measured strain value, $Ks$: the gauge factor of the used gauge)

The magnetostriction amount when the magnetic field direction was parallel to the long-side direction of the strain gauge age was defined as the parallel magnetostriction amount. On the other hand, the magnetostriction amount when the magnetic field direction was perpendicular to the long-side direction of the strain gauge was defined as the perpendicular magnetostriction amount. The magnetostriction constant was determined by the difference between the parallel magnetostriction amount and the perpendicular magnetostriction amount in accordance with Expression (1). When being processed with the long-side direction being parallel to the grinding mark direction, the parallel magnetostriction amount of this magnetostrictive member was 280 ppm, whereas the magnetostriction constant thereof was 285 ppm.

For the surface of the magnetostrictive member, the surface roughness Ra was measured at five locations in each of two directions, or the long-side direction and the short-side direction of the magnetostrictive member, with a surface roughness meter (VK-X1050 manufactured by Keyence Corporation) at a magnification of 20x, and their average was used as the surface roughness Ra. The surface roughness Ra in the long-side direction was 0.56 $\mu$m, whereas the surface roughness Ra in the short-side direction was 0.82 $\mu$m. Table 1 lists the manufacturing conditions and the evaluation results.

[Examples 2 and 3]

In Examples 2 and 3, to confirm a change in the parallel magnetostriction amount before and after the surface grinding, the surface of the magnetostrictive member was subjected to grinding with a cup grinding wheel, a conventional method, was then finished to be smooth by polishing so that no grinding marks by the surface grinding were left, and was cut into a predetermined size, and the parallel magnetostriction amount and the magnetostriction constant were measured. Then, with the long-side direction of the magnetostrictive member set to the same direction as the grinding direction during the surface grinding, the surface grinding with a flat grinding wheel was performed. The conditions other than the above were the same as in Example 1. Table 1 lists the manufacturing conditions and the evaluation results.

[Comparative Examples 1 and 2]

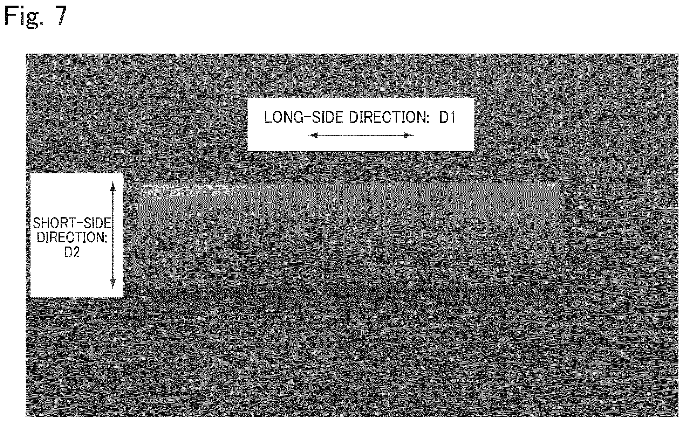

In Comparative Examples 1 and 2, the surface grinding in Examples 2 and 3 was performed with the short-side direction of the magnetostrictive member, instead of the long-side direction, set to the same direction as the grinding direction during the surface grinding. The conditions other than the above were the same as in Examples 2 and 3. Table 1 lists the manufacturing conditions and the evaluation results. Fig. 7 illustrates the magnetostrictive member of Comparative Example 1.

[Examples 4 and 5 and Comparative Examples 3 and 4]

Examples 4 and 5 and Comparative Examples 3 and 4 were performed with the direction in which the thin plate member was cut out of the single crystal in Examples 2 and 3 and Comparative Examples 1 and 2, respectively, changed to the direction perpendicular to the crystal growth direction. The conditions other than the above were the same as in Examples 4 and 5 and Comparative Examples 3 and 4. The measurement of the surface roughness was omitted. Table 1 lists the manufacturing conditions and the evaluation results.

[Examples 6 to 15 and Examples 16 to 23]

In Examples 6 to 15 and Examples 16 to 23, a plurality of thin plate members were produced from the same single crystal, and random magnetostrictive members were extracted from them. The other conditions were the same as in Example 4. That is to say, Examples 6 to 15 and Examples 16 to 23 are magnetostrictive members manufactured from the same single crystal. Table 1 lists the manufacturing conditions and the evaluation results. Table 2 and Table 3 list the results of variations in the parallel magnetostriction amount and the magnetostriction constant. The measurement of the surface roughness was omitted.

[Examples 24 to 29 and Comparative Examples 5 and 6]

Examples 24 to 29 and Comparative Examples 5 and 6 variously changed the cutting direction of the single crystal and the condition of the grain size (grit) of the grinding wheel used in the surface grinding to be compared with each other. Example 25 was performed in the same manner as in Example 2. Examples 24 and 26 were the same as Example 2 except that the condition of the grain size (grit) of the grinding wheel used in the surface grinding was changed. Example 28 was performed in the same manner as in Example 4. Examples 27 and 29 were the same as Example 4 except that the condition of the grain size (grit) of the grinding wheel used in the surface grinding was changed. Comparative Example 5 was the same as Comparative Example 1. Comparative Example 6 was the same as Comparative Example 3. The surface roughness in each example was performed in the same manner as in Example 1. Table 4 lists the manufacturing conditions and the evaluation results.

[Examples 30 to 33]

Examples 30 to 33 variously changed the condition of the plate thickness of the magnetostrictive member to be compared with each other. Example 31 was performed in the same manner as in Example 2. Examples 30 and 32 and Example 33 were the same as Example 2 except that the condition of the plate thickness adjusted in the surface grinding and the condition of the grain size (grit) of the used grinding wheel were changed. The surface roughness in each example was performed in the same manner as in Example 1. Table 5 lists the manufacturing conditions and the evaluation results.

[Examples 34 to 37 and Comparative Examples 7 and 9]

Examples 34 to 37 and Comparative Examples 7 to 9 set the angle between the direction of extension of the grooves 2 and the long-side direction D1 to 0°, 10°, 20°, 30°, 40°, 50° and 60°, respectively, to be compared with each other. The plate thickness was set to 0.5 mm. Example 34 was performed in the same manner as in Example 2. Example 35, Example 36, and Comparative Examples 8 and 9 were the same as Example 2 except that the grinding direction in the surface grinding was changed to 10°, 20°, 40°, and 60°, respectively. Example 37 and Comparative Example 8 were the same as Example 4 except that the grinding direction in the surface grinding was changed to 30° and 50°, respectively. The surface roughness in each example was performed in the same manner as in Example 1. Table 6 lists the manufacturing conditions and the evaluation results.

[Examples 38 to 42]

Examples 38 to 42 used a polycrystal as the material of the crystal. Examples 38 to 42 were the same as Example 2 except that the prepared single crystal was changed to a polycrystal. As the prepared polycrystal, with raw materials adjusted with a stoichiometric ratio of iron to gallium of 81:19, a cylindrical polycrystal of an Fe-Ga alloy grown by the vertical Bridgman (VB) method was prepared. The growth axis direction of the polycrystal was <100>. In the {100} plane of the upper face or the lower face of the polycrystal perpendicular to the crystal growth axis direction, the orientation was confirmed by X-ray diffraction. In this process, a top face sample of the crystal was measured with a Shimadzu sequential plasma emission spectrometer (ICPS-8100), and the concentration of the polycrystal had a gallium content of 17.5 to 19.0 at%. Table 7 lists the manufacturing conditions and the evaluation results.

[Table 1]

| | Single crystal cutting direction | Before groove formation (before surface grinding) | | Groove formation direction | Groove forming flat grinding wheel | After groove formation (after surface grinding) | | | | Surface roughness Ra (μm) | |
|---|---|---|---|---|---|---|---|---|---|---|---|
| | | Parallel magnetostriction amount (ppm) | Magnetostriction constant (ppm) | | | Plate thickness (mm) | Parallel magnetostriction amount (ppm) | Magnetostriction constant (ppm) | | Long-side direction | Short-side direction |
| Example 1 | Parallel | --- | --- | Long-side | #200 | 1 | 280 | 285 | | --- | --- |
| Example 2 | Parallel | 289 | 287 | Long-side | #200 | 1 | 277 | 265 | | 0.47 | 0.75 |
| Example 3 | Parallel | 13 | 177 | Long-side | #200 | 1 | 280 | 260 | | 0.53 | 0.82 |
| Comparative Example 1 | Parallel | 286 | 262 | Short-side | #200 | 1 | 40 | 262 | | 0.83 | 0.56 |
| Comparative Example 2 | Parallel | 19 | 205 | Short-side | #200 | 1 | 37 | 258 | | 0.79 | 0.51 |
| Example 4 | Perpendicular | 49 | 271 | Long-side | #200 | 1 | 287 | 291 | | --- | --- |
| Example 5 | Perpendicular | 271 | 277 | Long-side | #200 | 1 | 297 | 295 | | --- | --- |
| Comparative Example 3 | Perpendicular | 49 | 271 | Short-side | #200 | 1 | 55 | 290 | | --- | --- |
| Comparative Example 4 | Perpendicular | 271 | 277 | Short-side | #200 | 1 | 38 | 288 | | --- | --- |
| Example 6 | Perpendicular | 285 | 281 | Long-side | #200 | 1 | 274 | 262 | | --- | --- |
| Example 7 | Perpendicular | 292 | 267 | Long-side | #200 | 1 | 279 | 272 | | --- | --- |

(continued)

| | Single crystal cutting direction | Before groove formation (before surface grinding) | | After groove formation (after surface grinding) | | | | | Surface roughness Ra (μm) | |
|---|---|---|---|---|---|---|---|---|---|---|
| | | Parallel magnetostriction amount (ppm) | Magnetostriction constant (ppm) | Groove formation direction | Groove forming flat grinding wheel | Plate thickness (mm) | Parallel magnetostriction amount (ppm) | Magnetostriction constant (ppm) | Long-side direction | Short-side direction |
| Example 8 | Perpendicular | 289 | 287 | Long-side | #200 | 1 | 277 | 265 | --- | --- |
| Example 9 | Perpendicular | 287 | 266 | Long-side | #200 | 1 | 272 | 262 | --- | --- |
| Example 10 | Perpendicular | 276 | 219 | Long-side | #200 | 1 | 273 | 255 | --- | --- |
| Example 11 | Perpendicular | 203 | 222 | Long-side | #200 | 1 | 270 | 261 | --- | --- |
| Example 12 | Perpendicular | 95 | 223 | Long-side | #200 | 1 | 261 | 248 | --- | --- |
| Example 13 | Perpendicular | 13 | 177 | Long-side | #200 | 1 | 280 | 260 | --- | --- |
| Example 14 | Perpendicular | 309 | 202 | Long-side | #200 | 1 | 302 | 297 | --- | --- |
| Example 15 | Perpendicular | 222 | 250 | Long-side | #200 | 1 | 272 | 247 | --- | --- |
| Example 16 | Perpendicular | 19 | 237 | Long-side | #200 | 1 | 290 | 266 | --- | --- |
| Example 17 | Perpendicular | 14 | 205 | Long-side | #200 | 1 | 289 | 278 | --- | --- |
| Example 18 | Perpendicular | 267 | 230 | Long-side | #200 | 1 | 280 | 256 | --- | --- |

| | Single crystal cutting direction | Before groove formation (before surface grinding) | | After groove formation (after surface grinding) | | | | | | |
| | | Parallel magnetostri ction amount (ppm) | Magnetostri ction constant (ppm) | Groove format ion direct ion | Groov e formi ng flat grind ing wheel | Plate thickn ess (mm) | Parallel magnetostri ction amount (ppm) | Magnetostri ction constant (ppm) | Surface roughness Ra ($\mu$m) | |
| | | | | | | | | | Long-side direct ion | Short-side direct ion |
| Example 19 | Perpendic ular | 17 | 200 | Long-side | # 200 | 1 | 281 | 267 | --- | --- |
| Example 20 | Perpendic ular | 274 | 166 | Long-side | # 200 | 1 | 275 | 265 | --- | --- |
| Example 21 | Perpendic ular | 285 | 280 | Long-side | # 200 | 1 | 277 | 263 | --- | --- |
| Example 22 | Perpendic ular | 231 | 221 | Long-side | # 200 | 1 | 275 | 269 | --- | --- |
| Example 23 | Perpendic ular | 270 | 186 | Long-side | # 200 | 1 | 263 | 255 | --- | --- |

EP 4 064 372 A1

[Table 2]

| Parallel magnetostriction amount | | | | | | |
|---|---|---|---|---|---|---|
| | Average | MAX | MIN | MAX/average | MIN/average | Variation coefficient |
| Examples 6 to 15 | 276 | 302 | 261 | 1.094 | 0.946 | 10.0 |
| Examples 16 to 23 | 279 | 290 | 263 | 1.04 | 0.943 | 13.4 |

[Table 3]

| Magnetostriction constant | | | | | | |
|---|---|---|---|---|---|---|
| | Average | MAX | MIN | MAX/average | MIN/average | Variation coefficient |
| Examples 6 to 15 | 263 | 297 | 247 | 1.13 | 0.94 | 8.0 |
| Examples 16 to 23 | 265 | 278 | 255 | 1.050 | 0.963 | 6.8 |

[Table 4]

| | Single crystal cutting direction | Before groove formation (before surface grinding) | | After groove formation (after surface grinding) | | | | | | | |
|---|---|---|---|---|---|---|---|---|---|---|---|
| | | Parallel magnetostri ction amount (ppm) | Magnetostri ction constant (ppm) | Groove format ion direct ion | Groov e formi ng flat grind ing wheel | Plate thickn ess (mm) | Parallel magnetostri ction amount (ppm) | Magnetostri ction constant (ppm) | Surface roughness Ra ($\mu$m) | | |
| | | | | | | | | | Long-side direct ion | Short-side direct ion |
| Example 24 | Parallel | 150 | 250 | Long-side | # 40 | 1 | 250 | 247 | 1.104 | 4.095 |
| Example 25 | Parallel | 250 | 263 | Long-side | # 200 | 1 | 272 | 263 | 0.489 | 1.538 |
| Example 26 | Parallel | 75 | 269 | Long-side | # 400 | 1 | 279 | 260 | 0.424 | 0.821 |
| Example 27 | Perpendic ular | 211 | 248 | Long-side | # 40 | 1 | 232 | 241 | 1.073 | 2.802 |
| Example 28 | Perpendic ular | 50 | 271 | Long-side | # 200 | 1 | 257 | 251 | 0.518 | 1.347 |
| Example 29 | Perpendic ular | 172 | 268 | Long-side | # 400 | 1 | 277 | 264 | 0.396 | 0.733 |
| Compara tive Example 5 | Parallel | 95 | 250 | Short-side | # 200 | 1 | 33 | 275 | 1.421 | 0.523 |
| Compara tive Example 6 | Perpendic ular | 13 | 277 | Short-side | # 200 | 1 | 45 | 258 | 1.513 | 0.495 |

[Table 5]

| | Single crystal cutting direction | Before groove formation (before surface grinding) | | After groove formation (after surface grinding) | | | | | | | |
| | | Parallel magnetostriction amount (ppm) | Magnetostriction constant (ppm) | Groove formation direction | Groove forming flat grinding wheel | Plate thickness (mm) | Parallel magnetostriction amount (ppm) | Magnetostriction constant (ppm) | Surface roughness Ra ($\mu$m) | |
| | | | | | | | | | Long-side direction | Short-side direction |
|---|---|---|---|---|---|---|---|---|---|---|
| Example 30 | Parallel | 150 | 250 | Long-side | # 200 | 0.5 | 288 | 283 | 0.518 | 1.449 |
| Example 31 | Parallel | 250 | 263 | Long-side | # 200 | 1 | 284 | 270 | 0.473 | 1.347 |
| Example 32 | Parallel | 75 | 269 | Long-side | # 100 | 1.5 | 313 | 303 | 0.637 | 2.067 |
| Example 33 | Parallel | 95 | 250 | Long-side | # 40 | 2 | 285 | 280 | 1.083 | 3.541 |

[Table 6]

| | | Before groove formation (before surface grinding) | | After groove formation (after surface grinding) | | | | | | | |
| | Single crystal cutting direction | Parallel magnetostriction amount (ppm) | Magnetostriction constant (ppm) | Groove formation angle (°) | Groove forming flat grinding wheel | Plate thickness (mm) | Parallel magnetostriction amount (ppm) | Magnetostriction constant (ppm) | Surface roughness Ra ($\mu$m) | | |
| | | | | | | | | | Long-side direction | Short-side direction |
|---|---|---|---|---|---|---|---|---|---|---|
| Example 34 | Parallel | 150 | 250 | 0 | # 200 | 0.5 | 263 | 265 | 0.579 | 1.574 |
| Example 35 | Parallel | 250 | 263 | 10 | # 200 | 0.5 | 273 | 263 | 1.083 | 1.209 |
| Example 36 | Parallel | 75 | 269 | 20 | # 200 | 0.5 | 278 | 271 | 1.001 | 1.261 |
| Example 37 | Perpendicular | 7 | 248 | 30 | # 200 | 0.5 | 256 | 271 | 1.088 | 1.167 |
| Comparative Example 7 | Parallel | 95 | 250 | 40 | # 200 | 0.5 | 199 | 262 | 1.136 | 1. 118 |
| Comparative Example 8 | Perpendicular | 13 | 277 | 50 | # 200 | 0.5 | 104 | 254 | 1.172 | 1.136 |
| Comparative Example 9 | Parallel | 27 | 268 | 60 | # 200 | 0.5 | 59 | 263 | 0.941 | 0.9121 |

[Table 7]

| | Before groove formation (before surface grinding) | | | After groove formation (after surface grinding) | | | | | | |
|---|---|---|---|---|---|---|---|---|---|---|
| | Crystal cutting direction | Parallel magnetostriction amount (ppm) | Magnetostriction constant (ppm) | Groove formation direction | Groove forming flat grinding wheel | Plate thickness (mm) | Parallel magnetostriction amount (ppm) | Magnetostriction constant (ppm) | Surface roughness Ra (μm) Long-side direction | Surface roughness Ra (μm) Short-side direction |
| Example 38 | Parallel | 107 | 273 | Long-side | #200 | 1 | 273 | 270 | --- | --- |
| Example 39 | Parallel | 73 | 279 | Long-side | #200 | 1 | 260 | 260 | --- | --- |
| Example 40 | Parallel | 261 | 265 | Long-side | #200 | 1 | 262 | 260 | --- | --- |
| Example 41 | Parallel | 69 | 277 | Long-side | #200 | 1 | 248 | 251 | --- | --- |
| Example 42 | Parallel | 80 | 275 | Long-side | #200 | 1 | 287 | 287 | --- | --- |

[Conclusion]

From the results of the examples, the modification of the magnetostriction constant and the parallel magnetostriction amount is confirmed. From the results of the example, it is confirmed that the magnetostrictive member 1 of the present embodiment has the characteristics of a high magnetostriction constant and a high parallel magnetostriction amount and small variations in the magnetostriction constant and the parallel magnetostriction amount among members. From the results of the examples, it is confirmed that the method for manufacturing a magnetostrictive member of the aspect of the present invention can easily manufacture a magnetostrictive member having a high magnetostriction constant and a high parallel magnetostriction amount and small variations in the magnetostriction constant and the parallel magnetostriction amount among members.

The technical scope of the present invention is not limited to the aspects described in the embodiment and the like described above. One or more of the requirements described in the embodiment and the like described above may be omitted. The requirements described in the embodiment and the like described above can be combined as appropriate. To the extent permitted by law, the disclosure of Japanese Patent Application No. 2019-207723 and Japanese Patent Application No. 2020-144760, which are Japanese patent applications, and all the references cited in the embodiment and the like described above is hereby incorporated herein by reference and made a part hereof.

Description of Reference Signs

| | |
|---|---|
| 1 | Magnetostrictive member |
| 2 | Groove |
| 3 | Front face |
| 4 | Back face |
| D1 | Long-side direction |
| D2 | Short-side direction |
| S1 | Crystal preparation step |
| S2 | Crystal cutting step |
| S3 | Groove forming step |
| S4 | Cutting step |

**Claims**

1. A magnetostrictive member

   formed of a crystal of an iron-based alloy having magnetostrictive characteristics, and
   being a plate-like body having a long-side direction and a short-side direction,
   at least one of a front face and a back face of the plate-like body having a plurality of grooves extending in the long-side direction.

2. The magnetostrictive member according to claim 1, wherein the face having the grooves has a surface roughness Ra in the long-side direction smaller than a surface roughness Ra in the short-side direction.

3. The magnetostrictive member according to claim 2, wherein the surface roughness Ra in the long-side direction is 0.3 $\mu$m or more and 1.5 $\mu$m or less, and the surface roughness Ra in the short-side direction is 0.6 $\mu$m or more and 4.5 $\mu$m or less.

4. The magnetostrictive member according to any one of claims 1 to 3,

   having a magnetostriction constant of 200 ppm or more, and
   having a parallel magnetostriction amount of 200 ppm or more, the parallel magnetostriction amount being a magnetostriction amount when a magnetic field parallel to the long-side direction is applied and a magnetostriction amount in the long-side direction is saturated.

5. The magnetostrictive member according to any one of claims 1 to 4, wherein the front face and the back face of the plate-like body have the grooves.

6. The magnetostrictive member according to any one of claims 1 to 5, wherein a direction of the grooves extending in the long-side direction of the plate-like body is within 30° with respect to the long-side direction.

7. The magnetostrictive member according to any one of claims 1 to 6, wherein a thickness of the plate-like body is 0.3 mm or more and 2 mm or less.

8. The magnetostrictive member according to any one of claims 1 to 7, wherein the crystal is a single crystal.

9. The magnetostrictive member according to any one of claims 1 to 8, wherein the iron-based alloy is an Fe-Ga alloy.

10. The magnetostrictive member according to any one of claims 1 to 9, wherein the grooves are formed by surface grinding.

11. The magnetostrictive member according to any one of claims 1 to 10, being a plurality of magnetostrictive members manufactured from the crystal that is one crystal, wherein
the magnetostrictive members have a variation in a parallel magnetostriction amount within 10%, the parallel magnetostriction amount being a magnetostriction amount when a magnetic field parallel to the long-side direction is applied and a magnetostriction amount in the long-side direction is saturated.

12. A method for manufacturing a magnetostrictive member, the method comprising forming, on at least one of a front face and a back face of a plate-like body formed of a crystal of an iron-based alloy having magnetostrictive characteristics and having a long-side direction and a short-side direction, a plurality of grooves extending in the long-side direction.

13. The method for manufacturing a magnetostrictive member according to claim 12, comprising forming the grooves by surface grinding.

14. The method for manufacturing a magnetostrictive member according to claim 13, comprising performing the surface grinding using a grinding wheel of #40 or more and #500 or less.

15. The method for manufacturing a magnetostrictive member according to any one of claims 12 to 14, comprising forming the grooves so as to achieve a magnetostriction constant of 200 ppm or more and a parallel magnetostriction amount of 200 ppm or more, the parallel magnetostriction amount being a magnetostriction amount when a magnetic field parallel to the long-side direction is applied and a magnetostriction amount in the long-side direction is saturated.

16. The method for manufacturing a magnetostrictive member according to any one of claims 12 to 15, comprising:

manufacturing a plurality of the magnetostrictive members from the crystal that is one crystal; and
in the magnetostrictive members manufactured from the one crystal, forming the grooves so as to achieve a variation in a parallel magnetostriction amount within 10%, the parallel magnetostriction amount being a magnetostriction amount when a magnetic field parallel to the long-side direction is applied and a magnetostriction amount in the long-side direction is saturated.

Fig. 1

(A)

(B)

Fig. 2

| CRYSTAL PREPARATION STEP | S1 |
| CRYSTAL CUTTING STEP | S2 |
| GROOVE FORMING STEP | S3 |
| CUTTING STEP | S4 |

Fig. 3

SINGLE CRYSTAL

FIRST {100} PLANE
THIRD <100> AXIS
SECOND <100> AXIS

FIRST <100> AXIS

THIN PLATE MEMBER

FIRST {100} PLANE
THIRD {100} PLANE — LONG-SIDE DIRECTION
SECOND {100} PLANE

MAGNETOSTRICTIVE MEMBER

LONG-SIDE DIRECTION
SECOND {100} PLANE

# Fig. 4

SINGLE CRYSTAL

FIRST {100} PLANE

THIRD <100> AXIS

SECOND <100> AXIS

FIRST <100> AXIS

THIN PLATE MEMBER

FIRST {100} PLANE

LONG-SIDE DIRECTION

SECOND {100} PLANE

THIRD {100} PLANE

MAGNETOSTRICTIVE MEMBER

THIRD {100} PLANE

FIRST {100} PLANE

LONG-SIDE DIRECTION

SECOND {100} PLANE

## Fig. 5

SINGLE CRYSTAL

FIRST {100} PLANE
THIRD ⟨100⟩ AXIS
SECOND ⟨100⟩ AXIS
FIRST ⟨100⟩ AXIS

THIN PLATE MEMBER

FIRST {100} PLANE

FIRST {100} PLANE
LONG-SIDE DIRECTION
THIRD {100} PLANE
SECOND {100} PLANE

FIRST {100} PLANE
LONG-SIDE DIRECTION
THIRD {100} PLANE
SECOND {100} PLANE

MAGNETOSTRICTIVE MEMBER          MAGNETOSTRICTIVE MEMBER

Fig. 6

PARALLEL MAGNETIC FIELD
$\varepsilon$ (∥)

STRAIN GAUGE

1

PERPENDICULAR
MAGNETIC FIELD

$\varepsilon$ (⊥)

STRAIN DETECTION DIRECTION

⟨100⟩

⟨100⟩

⟨100⟩

Fig. 7

<table>
<tr><td colspan="2" align="center">**INTERNATIONAL SEARCH REPORT**</td><td colspan="2">International application No.<br><br>PCT/JP2020/041260</td></tr>
</table>

A. CLASSIFICATION OF SUBJECT MATTER
Int. Cl. H01L41/12(2006.01)i, H01L41/20(2006.01)i, H01L41/47(2013.01)i,
C30B29/52(2006.01)i
FI: H01L41/12, H01L41/47, H01L41/20, C30B29/52
According to International Patent Classification (IPC) or to both national classification and IPC

B. FIELDS SEARCHED

Minimum documentation searched (classification system followed by classification symbols)
Int. Cl. H01L41/12, H01L41/20, H01L41/47, C30B29/52

Documentation searched other than minimum documentation to the extent that such documents are included in the fields searched
Published examined utility model applications of Japan      1922-1996
Published unexamined utility model applications of Japan   1971-2020
Registered utility model specifications of Japan           1996-2020
Published registered utility model applications of Japan   1994-2020

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y<br>A | JP 10-239177 A (MATSUSHITA ELECTRIC INDUSTRIAL CO., LTD.) 11 September 1998, paragraphs [0019], [0020], fig. 1, 3 | 1, 5, 12<br>1, 5, 7-9<br>2-4, 6, 10, 11, 13-16 |
| Y<br>A | JP 2016-138028 A (NIPPON KOSHUHA STEEL CO., LTD.) 04 August 2016, paragraphs [0026]-[0029] | 1, 5, 7-9<br>2-4, 6, 10-16 |
| A | JP 2002-250662 A (TDK CORP.) 06 September 2002, entire text, all drawings | 1-16 |
| A | JP 2007-294880 A (TDK CORP.) 08 November 2007, entire text, all drawings | 1-16 |

☐ Further documents are listed in the continuation of Box C.   ☒ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>10.12.2020 | Date of mailing of the international search report<br>22.12.2020 |
|---|---|
| Name and mailing address of the ISA/<br>  Japan Patent Office<br>  3-4-3, Kasumigaseki, Chiyoda-ku,<br>  Tokyo 100-8915, Japan | Authorized officer<br><br>Telephone No. |

Form PCT/ISA/210 (second sheet) (January 2015)

**INTERNATIONAL SEARCH REPORT**

Information on patent family members

International application No.

PCT/JP2020/041260

| Patent Documents referred to in the Report | Publication Date | Patent Family | Publication Date |
|---|---|---|---|
| JP 10-239177 A | 11.09.1998 | (Family: none) | |
| JP 2016-138028 A | 04.08.2016 | US 2017/0317266 A1 paragraphs [0038]-[0041]<br>US 2018/0233654 A1<br>WO 2016/121132 A1<br>EP 3252192 A1<br>CN 107109683 A | |
| JP 2002-250662 A | 06.09.2002 | US 2002/0078765 A1 entire text, all drawings<br>EP 1217351 A1 | |
| JP 2007-294880 A | 08.11.2007 | US 2007/0230043 A1 entire text, all drawings<br>CN 101071678 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016028831 A
- JP 2016138028 A
- JP H04108699 A
- JP 2015517024 W
- WO 2011158473 A
- JP 2019207723 A
- JP 2020144760 A

**Non-patent literature cited in the description**

- **TOSHIYUKI UENO.** *Journal of Japan Society for Precision Engineering,* 2013, vol. 79 (4), 305-308